# EUROPEAN PATENT APPLICATION

(11) **EP 1 231 718 A2**
(43) Date of publication of application: **14.08.2002**
(21) Application number: 02250619.0
(22) Date of filing: 29.01.2002
(51) Int. Cl.: H03M 13/15

(54) **Reed-Solomon decoder for processing (M) or (2M) bit data, and decoding method therefor**

(30) Priority: 07.02.2001 KR 2001005970
(71) Applicant: Samsung Electronics Co., Ltd., Suwon-city, Kyungki-do (KR)
(72) Inventor: Kim, Joo-seon, Jungwon-gu, Sungnam-city, Kyungki-do (KR)
(74) Representative: Robinson, Ian Michael

(57) **Abstract**

A Reed-Solomon (RS) decoder for a digital communication and/or storing system, and a decoding method therefor. The RS decoder includes a storing part (210), a calculation part (230,250) for calculating an error location and an error value from 2m bit data from the storing part, and a control part (240,260) for correcting an error of the data according to the error location and the error value, and controlling the calculation part to output a decoded signal. As a result, the RS codes of various length can be decoded and processed at a high speed.

## Description

The present invention relates to a Reed-Solomon (RS) decoder and a decoding method therefor, and more particularly to an RS decoder for processing m or (2m) bit data by using two RS cores in parallel, and a decoding method therefor.

In order to detect and correct an error during transmission or reproduction of data, a general digital communication and storing system employs an error correction code method in which transmission data is added with redundancy for error correction. The error correction code method is divided into a block code method and a tree code method. Here, block codes are divided into linear codes and nonlinear codes. The linear codes are divided into cyclic codes and non-cyclic codes. The cyclic code includes BCH code. The BCH code that forms code words in symbol units is the Reed-Solomon code (hereinafter, referred to as 'RS code'). For a code word of a certain correction capacity, the cyclic code or linear code requires more parity than the RS code. Accordingly, the RS codes of the cyclic code method are relatively widely used in the digital communication and storing system when transmitting or storing a large amount of data. The RS code is a symbol-unit error correction code for detecting an error location and an error value from reception data according to a series of operation processes. In addition, the RS code has an excellent error correction ability for random and burst errors in a channel, and easily selects codes for obtaining a desired error rate. Especially, when used as a product code for generating an inner code and an outer code for the same data, the RS code for the digital communication and storing system transmitting or storing a large amount of data has an excellent correction ability.

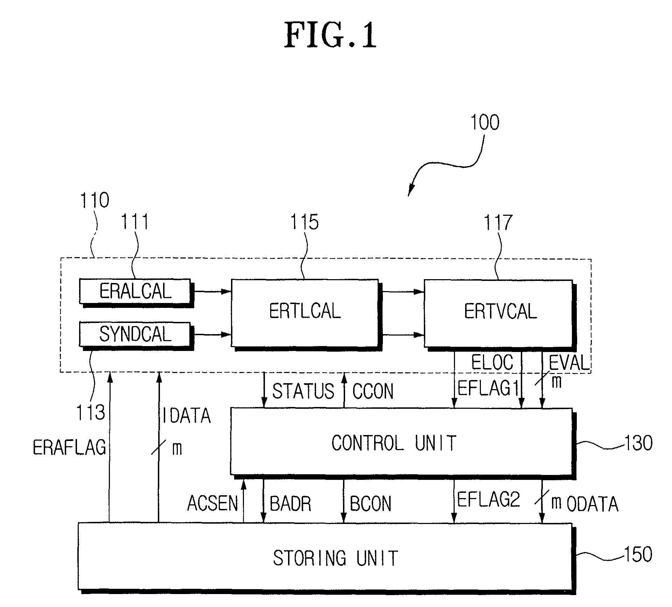

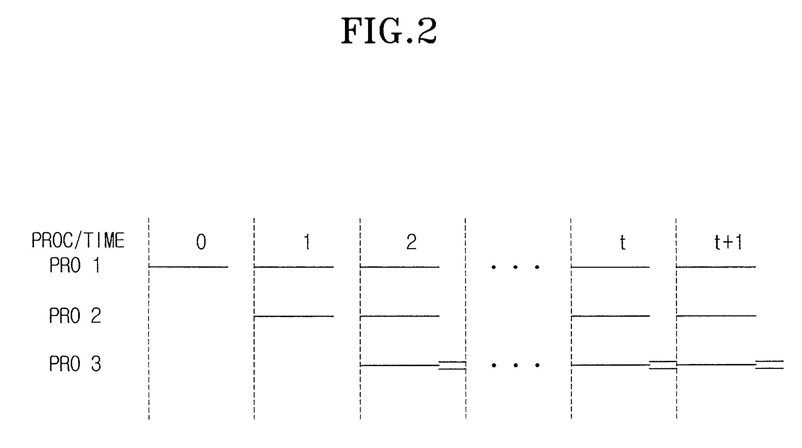

A conventional RS decoder for processing (m) bit data will now be explained with reference to Figures 1 and 2.

The conventional RS decoder 100 includes an RS core 110, a control part 130 and a storing part 150.

The RS core 110 includes an erasure location polynomial calculation part (ERALCAL) 111, a syndrome polynomial calculation part (SYNDCAL) 113, an errata location polynomial calculation part (ERTLCAL) 115, and an error value calculation part (ERTVCAL) 117.

Here, an erasure is defined as an error whose location can be detected. An errata is the generic name for an error or an erasure.

The control unit 130 connects the RS core 110 and the storing part 150, and generates a control signal CCON for controlling the RS core 110.

The storing unit 150 outputs to the control part 130 a data enable signal ACSEN for enabling the RS core 110 to access sequentially-inputted (m) bit data IDATA. According to the data enable signal ACSEN, the control unit 130 outputs a block offset address BADR and a block control signal BCON to the storing unit 150. The RS core 110 performs various operations by using the (m) bit data IDATA and an erasure flag ERAFLAG from the storing unit 150. The erasure flag ERAFLAG is an error flag calculated in the preceding step.

The SYNDCAL 113 calculates a syndrome polynomial from the sequentially-inputted (m) bit data IDATA.

The ERALCAL 111 calculates an erasure location polynomial having a root of an erasure location from the sequentially-inputted erasure flags ERAFLAG of the preceding step.

The ERTLCAL 115 calculates an errata location polynomial having a root of an errata location from the calculated syndrome polynomial and erasure location polynomial.

The ERTVCAL 117 calculates an error location ELOC and an error value EVAL from the calculated errata location polynomial and syndrome polynomial. The resultant error location ELOC, error value EVAL, error flag EFLAG1 and control signal STATUS are outputted to the control unit 130.

The control unit 130 decodes the data and corrects the error by using the output signals from the RS core 110, and outputs the error flag EFLAG2 and the decoded (m) bit data ODATA to the storing unit 150.

A conventional method for correcting an error of the RS decoder includes an inner code correction step and an outer code correction step.

The inner code correction step will be explained below. When a bit stream is inputted from a channel to an RS decoder 100, the bit stream is converted into (m) bit data symbols, and stored in the storing unit 150. This (m) bit data symbol is an error correction code block (ECC block) which satisfies the product of an inner code word length N1 and an outer code word length N2. When the data symbol is stored in the storing unit 150, the error correction starts. The RS core 110 sequentially reads the data from the storing unit 150 in (m) bit units, and the SYNDCAL 113 calculates the syndrome polynomial. After the syndrome polynomial is calculated, the error location polynomial is calculated. The error location and the error value are calculated from the calculated error location polynomial and syndrome polynomial. The error is corrected by reading an error symbol corresponding to the calculated error location, and then adding the error symbol to the calculated error value. Such a corrected error symbol is stored in the storing unit 150. If the error is detected precisely, '0' is stored as the erasure flag EFLAG2 value. Otherwise, '1' is stored as the erasure flag EFLAG2 value.

The outer code correction step is performed in the same order as the inner code correction step, except that the error flag location stored in the outer code corrections step is regarded as the erasure flag (ERAFLAG). Therefore, the erasure flag ERAFLAG is read with the data in calculating the syndrome location polynomial, and the erasure location polynomial is calculated.

In Figure 2, a lateral axis indicates time and a longitudinal axis indicates a procedure. In time period 0, a first procedure (proc1) is performed so that the erasure location polynomial and the syndrome polynomial are calculated by reading the erasure flag ERAFLAG and the first (m) bit data IDATA. In time period 1, the first procedure (prod) is performed on the second (m) bit data, and a second procedure (proc2) for calculating the errata location polynomial is performed on the first (m) bit data. In time period 2, the first procedure (proc1) is performed on the third (m) bit data, the second procedure (proc2) for calculating the errata location polynomial is performed on the second (m) bit data, and a third procedure (proc3) for calculating the error location and the error value of the first (m) bit data, and updating the storing unit 150 is performed. That is, in the parallel processing method of a pipeline structure, while only the first procedure (proc1) is performed in time period 0, the first to third procedures (proc1-proc3) are simultaneously performed in time period 't'.

Even with the parallel processing of pipelined structure, however, the conventional decoder using the single RS core cannot satisfy the demand of a high-speed digital communication and storing system. In order to process the data suitable for the high-speed digital communication and storing system, the conventional RS decoder must have faster operation clocks. However, the RS decoder, calculating a large amount of data, has limited operation clocks. In addition, when the speed of the operation clocks is increased to process the data at a high speed, an interface between the storing part and the RS core cannot be stabilized.

Accordingly, a primary object of the present invention is to provide an RS decoder for processing (m) or (2m) bit data which can satisfy the demand of a high-speed data communication and storing system.

Another object of the present invention is to provide an RS decoder for processing (m) or (2m) bit data which can satisfy the demand of a high-speed data communication and storing system, without increasing the speed of the operation clocks.

Yet another object of the present invention is to provide an RS decoder for processing (m) or (2m) bit data which can be used for a complicated error correction system.

An object of the present invention is to provide a method for an RS decoder to process (m) or (2m) bit data which satisfies the demand of a high-speed data communication and storing system.

Another object of the present invention is to provide a method for an RS decoder to process (m) or (2m) bit data which can satisfy the demand of a high-speed data communication and storing system, without increasing the speed of the operation clocks.

Another object of the present invention is to provide a method for an RS decoder to process (m) or (2m) bit data which can be used for a complicated error correction system.

According to a first aspect of the present invention there is provided an RS decoder including a storing part; a calculation part for calculating an error location and an error value from (2m) bit data from the storing part; and a control part for correcting an error of the data from the calculation part according to the error location and the error value, and controlling the calculation part to output a decoded signal.

In one embodiment of the present invention, the calculation part includes an erasure location polynomial calculation part for calculating an erasure location polynomial from an erasure flag from the storing part; a first syndrome polynomial calculation part for calculating a first syndrome polynomial from the data read from the storing part; a second syndrome polynomial calculation part for calculating a second syndrome polynomial from the data read from the storing part; a first errata location polynomial calculation part for calculating a first errata location polynomial from the calculated erasure location polynomial and first syndrome polynomial, and outputting the delayed first syndrome polynomial; a first error location/value calculation part for calculating a first error flag, a first error location and a first error value from the first errata location polynomial and the delayed first syndrome polynomial; a second errata location polynomial calculation part for calculating a second errata location polynomial from the calculated erasure location polynomial and second syndrome polynomial, and outputting the delayed second syndrome polynomial; and a second error location/value calculation part for calculating a second error flag, a second error location and a second error value from the second errata location polynomial and the delayed second syndrome polynomial.

In another embodiment of the present invention, the calculation part includes a first RS core for calculating a first error location and a first error value from the data read from the storing part; and a second RS core for calculating a second error location and a second error value from the data read from the storing part.

In order to operate the RS decoder in (m) bit units, an (m) bit correction mode is set, in which the (m) bit data is stored in an up (m) bit memory of the storing part, and the second RS core is disabled not to access the storing part.

The first RS core includes an erasure location polynomial calculation part for calculating an erasure location polynomial from an erasure flag read from the storing part; a first syndrome polynomial calculation part for calculating a first syndrome polynomial from the data read from the storing part; a first errata location polynomial calculation part for calculating a first errata location polynomial from the calculated erasure location polynomial and first syndrome polynomial, and outputting the delayed first syndrome polynomial; and a first error location/value calculation part for calculating a first error flag, a first error location and a first error value from the first errata location polynomial and the delayed first syndrome polynomial.

Preferably, the first syndrome polynomial calculation part satisfies Sⱼ = α^{j}(Sⱼ₋₁α^{j}+UN)+DM when (2m) bit data is inputted, and satisfies Sⱼ = Sⱼ₋₁α^{j}+UM when (m) bit data is inputted. Where Sⱼ indicates a current state syndrome polynomial, Sⱼ₋₁ is a preceding state syndrome polynomial, α^{j} is a root of a generated polynomial, UM is up (m) bits of the (2m) bit data, and DM is down (m) bits of the (2m) bit data.

Preferably, the first syndrome polynomial calculation part comprises: a first syndrome storing part for temporarily storing a calculation result of the first syndrome polynomial; a first multiplier for multiplying the syndrome polynomial from the first syndrome storing part by a root α^{j}(j=0, 1, ..., N-K-1) of the generated polynomial; a first adder for adding the output from the first multiplier to up (m) (UM) bits of the input data; a first (m) bit multiplexer for outputting 1 or α^{j} according to the (m) or (2m) bit mode; a second multiplier for multiplying the output from the first adder by the output from the first (m) bit multiplexer; a second (m) bit multiplexer for outputting 0 or down (m) (DM) bits of the input data according to the (m) or (2m) bit mode; and a second adder for adding the output from the second multiplier to the output from the second (m) bit multiplexer, the first syndrome storing part temporarily storing and outputting the output from the second adder; wherein UM is up (m) bits of the (2m) bit data, and DM is down (m) bits of the (2m) bit data.

Preferably, the second RS core includes a second syndrome polynomial calculation part for calculating a second syndrome polynomial from the data read from the storing part; a second errata location polynomial calculation part for calculating a second errata location polynomial from the calculated erasure location polynomial and second syndrome polynomial, and outputting the delayed second syndrome polynomial; and a second error location/value calculation part for calculating a second error flag, a second error location and a second error value from the second errata location polynomial and the delayed second syndrome polynomial.

The second syndrome polynomial calculation part satisfies Sⱼ = α^{j}(Sⱼ₋₁α^{j}+UM)+DM when (2m) bit data is inputted, and satisfies Sⱼ = Sⱼ₋₁α^{j}+DM when (m) bit data is inputted. Where Sⱼ indicates a current state syndrome polynomial, Sⱼ₋₁ is a preceding state syndrome polynomial, α^{j} is a root of a generated polynomial, UM is up (m) bits of the (2m) bit data, and DM is down (m) bits of the (2m) bit data.

Preferably, the second syndrome polynomial calculation part comprises: a second syndrome storing part for temporarily storing a calculation result of the second syndrome polynomial; a third (m) bit multiplexer for outputting 1 or α^{j} according to the (m) or (2m) bit mode; a third multiplier for multiplying the output from the second syndrome storing part by the output from the third (m) bit multiplexer; a fourth (m) bit multiplexer for outputting 0 or up (m) (UM) bits of the input data according to the (m) or (2m) bit mode; a third adder for adding the output from the third multiplier to the output from the fourth (m) bit multiplexer; and a fourth multiplier for multiplying the output from the third adder by a root α^{j}(j=0, 1, ..., N-K-1) of the generated polynomial; and a fourth adder for adding the output from the fourth multiplier to down (m) (DM) bits of the input data, the second syndrome storing part storing and outputting the output from the fourth adder; wherein UM is up (m) bits of the (2m) bit data, and DM is down (m) bits of the (2m) bit data.

According to a second aspect of the present invention there is provided a Reed-Solomon decoder for processing m or 2m bit data, comprising: a storing part for storing 2m bit data; a main control part for controlling the storing part; a first RS core for calculating a first error location and a first error value from the data read from the storing part; a first RS core control part for controlling the first RS core under the control of the main control part; a second RS core for calculating a second error location and a second error value from the data read from the storing part; and a second RS core control part for controlling the second RS core under the control of the main control part.

According to a third aspect of the present invention there is provided an RS decoding method that includes the steps of reading the data to be decoded and an erasure flag read from the storing part; calculating an error location and an error value from the read data; and correcting an error of the data according to the calculated error location and error value, and decoding the data.

Preferably, the data is read in (2m) bit units in the data reading step.

The data reading step includes an erasure location polynomial calculation step for calculating an erasure location polynomial from the erasure flag from the storing part; a first syndrome polynomial calculation step for calculating a first syndrome polynomial from the read data; a second syndrome polynomial calculation step for calculating a second syndrome polynomial from the read data; a first errata location polynomial calculation step for calculating a first errata location polynomial from the calculated erasure location polynomial and first syndrome polynomial, and outputting the delayed first syndrome polynomial; a first error location/value calculation step for calculating a first error flag, a first error location and a first error value from the first errata location polynomial and the delayed first syndrome polynomial; a second errata location polynomial calculation step for calculating a second errata location polynomial from the calculated erasure location polynomial and second syndrome polynomial, and outputting the delayed second syndrome polynomial; and a second error location/value calculation step for calculating a second error flag, a second error location and a second error value from the second errata location polynomial and the delayed second syndrome polynomial.

The calculation step includes a first calculation step for calculating a first error location and a first error value from the read data; and a second calculation step for calculating a second error location and a second error value from the read data.

The first calculation step includes an erasure location polynomial calculation step for calculating an erasure location polynomial from the erasure flag; a first syndrome polynomial calculation step for calculating a first syndrome polynomial from the read data; a first errata location polynomial calculation step for calculating a first errata location polynomial from the calculated erasure location polynomial and first syndrome polynomial, and outputting the delayed first syndrome polynomial; and a first error location/value calculation step for calculating a first error flag, a first error location and a first error value from the first errata location polynomial and the delayed first syndrome polynomial.

Preferably, the first syndrome polynomial calculation step satisfies Sⱼ = α^{j}(Sⱼ₋₁α^{j}+UM)+DM when (2m) bit data is inputted, and satisfies Sⱼ = Sⱼ₋₁α^{j}+UM when (m) bit data is inputted. Sⱼ indicates a current state syndrome polynomial, Sⱼ₋₁ is a preceding state syndrome polynomial, α^{j} is a root of a generated polynomial, UM is up (m) bits of the (2m) bit data, and DM is down (m) bits of the (2m) bit data.

The second calculation step includes a second syndrome polynomial calculation step for calculating a second syndrome polynomial from the read data; a second errata location polynomial calculation step for calculating a second errata location polynomial from the calculated erasure location polynomial and second syndrome polynomial, and outputting the delayed second syndrome polynomial; and a second error location/value calculation step for calculating a second error flag, a second error location and a second error value from the second errata location polynomial and the delayed second syndrome polynomial.

The second syndrome polynomial calculation step satisfies Sⱼ = α^{j}(Sⱼ₋₁α^{j}+UM)+DM when (2m) bit data is inputted, and satisfies Sⱼ = Sⱼ₋₁α^{j}+DM when (m) bit data is inputted. Sⱼ indicates a current state syndrome polynomial, Sⱼ₋₁ is a preceding state syndrome polynomial, α^{j} is a root of a generated polynomial, UM is up (m) bits of the (2m) bit data, and DM is down (m) bits of the (2m) bit data.

According to a fourth aspect of the present invention there is provided an inner code correction method of an RS production code comprising the steps of calculating a first syndrome polynomial from inner code words received in (2m) bit units; calculating a second syndrome polynomial from inner code words received in (2m) bit units; calculating first and second errata location polynomials from the calculated first and second syndrome polynomials and an erasure location polynomial; and calculating first and second error values and first and second error locations according to the first and second errata location polynomials and the first and second syndrome polynomials, wherein the errors are corrected in (m) bit units. The order of the first and second syndrome polynomial calculation can be changed.

According to a fifth aspect of the present invention there is provided an outer code correction method of an RS production code that includes the steps of calculating a first syndrome polynomial from up (m) bits of read (2m) bit outer codes and a second syndrome polynomial from down (m) bits of read (2m) bit outer codes, and simultaneously calculating an erasure location polynomial by reading an erasure flag; calculating first and second errata location polynomials from the first and second syndrome polynomials and the erasure location polynomial; and calculating an error value and an error location from the first and second errata location polynomials and the first and second syndrome polynomials, the errors being alternately corrected in (m) bit units.

Advantageously, in the present invention, the RS decoder for processing (m) or (2m) bit data and the decoding method therefor can process the data at a high speed, by using the RS cores in parallel. Therefore, it is unnecessary to increase a speed of operation clocks, thus stabilizing an interface between the data storing part and the RS core, and increasing reliability of the system. Moreover, the syndrome polynomial calculation part of the RS core selectively processes (m) or (2m) bit data. As a result, the present invention can be employed for CD/DVD data processing of a complicated error correction system.

For a better understanding of the invention, and to show how embodiments of the same may be carried into effect, reference will now be made, by way of example, to the accompanying diagrammatic drawings in which:
Figure 1 is a block diagram illustrating a conventional RS decoder for processing (m) bit data;
Figure 2 is a timing diagram showing data process of the RS decoder in Figure 1 in each time period;
Figure 3 illustrates data structure of an RS production code;
Figure 4 is a block diagram illustrating an RS decoder for processing (m) or (2m) bit data in accordance with the present invention;
Figure 5 is a timing diagram showing inner code data processing of the RS decoder in Figure 4 in each time period;
Figure 6 is a timing diagram showing outer code data processing of the RS decoder in Figure 4 in each time period; and
Figure 7 is a detailed structure diagram illustrating a syndrome calculation part of the RS decoder in Figure 4.
Figure 8 is a diagram illustrating a Reed-Soloman decoding method in accordance with the present invention.
Figure 9 is a diagram illustrating a data reading method in accordance with the present invention.
Figure 10 is a diagram illustrating a calculation method in accordance with the present invention.
Figure 11 is a diagram illustrating a first and a second calculation method in accordance with the present invention.

A Reed-Solomon (RS) decoder for processing (m) or (2m) bit data, and a decoding method therefor will now be described with reference to the accompanying drawings.

For a reference, the character 'm' of the (m) or (2m) bit data is a unit that represents amount of data processing, for example, a number of bits constituting a symbol, which may be appropriately determined according to a data representation method. Hereinafter, the basic unit that represents amount of data processing will be represented by 'm'.

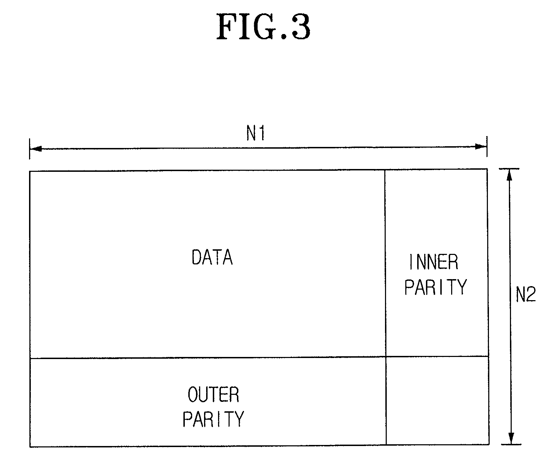

RS(N, K, d) is an RS code whose code word length is 'N', information word length is 'K', and minimum hamming distance is 'd' . One of the characteristics of the RS code is that the minimum hamming distance (d) is equal to (N-K+1), where 'N-K' is a parity number. When 'N-K' is 'R', 'R' is equal to (d-1). The formula N-K=R=d-1 is for a definition of the number of parity. According to the formula, for example, if an information word is 8 bits (K=8), the length of the signal word is 12 (N=12)and the number of the parity is 4 (R=N-K). When the number of symbols correctable by the RS code is 't', 't' is equal to [(d-1)/2]. In the code word including 'e' erasures, the RS code can correct 't' errors and 'e' erasures which satisfy 'd≥2t+e+1'. The RS code for a digital communication and storing system for transmitting or storing a large amount of data generally uses a product code that encodes an inner code and an outer code generated with respect to the same data. Figure 3 illustrates data structure of the RS production code RSPC. The RS production code includes data, an inner parity and an outer parity. Here, an inner code length is 'N1' and an outer code length is 'N2'.

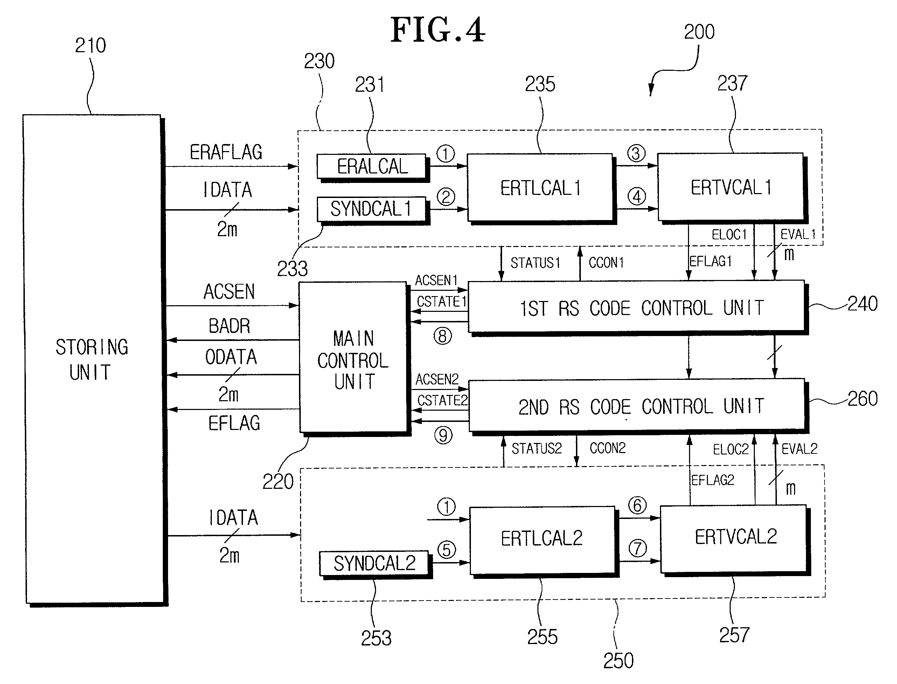

Figure 4 is a block diagram illustrating an RS decoder 200 for processing (m) or (2m) bit data in accordance with a first embodiment of the present invention.

Referring to Figure 4, the RS decoder 200 includes a storing unit 210, a main control unit 220 for controlling the storing unit 210 and overall operation of the decoder, a first RS core 230, a first RS core control unit 240, a second RS core 250 and a second RS core control unit 260.

The storing unit 210 can be a buffer or a memory for storing (2m) bit data.

The first RS core 230 calculates a first error location ELOC1 and a first error value EVAL1 from the data IDATA read from the storing unit 210.

The first RS core control unit 240 controls the first RS core 230 under the control of the main control unit 220.

The second RS core 250 calculates a second error location ELOC2 and a second error value EVAL2 from the data IDATA read from the storing unit 210.

The second RS core control unit 260 controls the second RS core 250 under the control of the main control unit 220.

The first RS core 230 includes an erasure location polynomial calculation part ERALCAL 231, a first syndrome polynomial calculation part SYNDCAL1 233, a first errata location polynomial calculation part ERTLCAL1 235 and a first error location/value calculation part ERTVCAL1 237.

The ERALCAL 231 calculates an erasure location polynomial ① from an erasure flag ERAFLAG read from the storing unit 210. The erasure flag ERAFLAG is an error flag (EFLAG) calculated in a preceding step. The erasure is data that has information about a position of an error but not about a value of the error. Referring to Figure 3, the horizontal axis indicates an internal signal correction direction. If there are data which are not corrected even after the process of correcting the internal signal, it means that an error has occurred in the data along the horizontal axis, and accordingly, one error flag is stored. And, this stored error flag is, from the horizontal axis point of view, seen as an erasure flag because it indicates a position where the error occurs.

The SYNDCAL1 233 calculates a first syndrome polynomial ② from the data IDATA read from the storing unit 210.

The ERTLCAL1 235 calculates a first errata location polynomial ③ from the calculated erasure location polynomial ① and first syndrome polynomial ②, and outputs the delayed first syndrome polynomial ④.

The ERTVCAL1 237 calculates a first error flag EFLAG1, a first error location ELOC1 and a first error value EVAL1 from the first errata location polynomial ③ and the delayed first syndrome polynomial ④.

The second RS core 250 includes a second syndrome polynomial calculation part SYNDCAL2 253, a second errata location polynomial calculation part ERTLCAL2 255 and a second error location/value calculation part ERTVCAL2 257.

The SYNDCAL2 253 calculates a second syndrome polynomial ⑤ from the data IDATA read from the storing unit 210.

The ERTLCAL2 255 calculates a second errata location polynomial ⑥ from the calculated erasure location polynomial ① and second syndrome polynomial ⑤, and outputs the delayed second syndrome polynomial ⑦.

The ERTVCAL2 257 calculates a second error flag EFLAG2, a second error location ELOC2 and a second error value EVAL2 from the second errata location polynomial ⑥ and the delayed second syndrome polynomial ⑦.

The outputs ⑧ and ⑨ are values including the error values that are calculated from the first RS core 230 and the second RS core 250, respectively, and that respectively flow from the first RS core control unit 220 and from the second RS core control unit 260 to the main control unit 220.

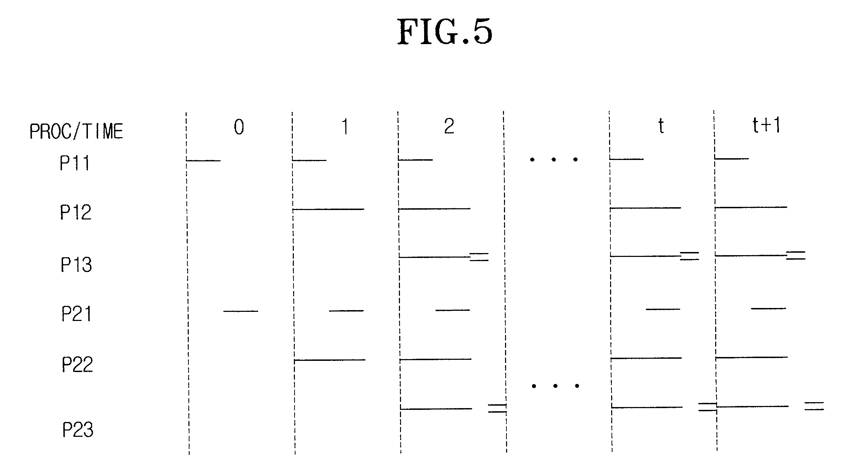

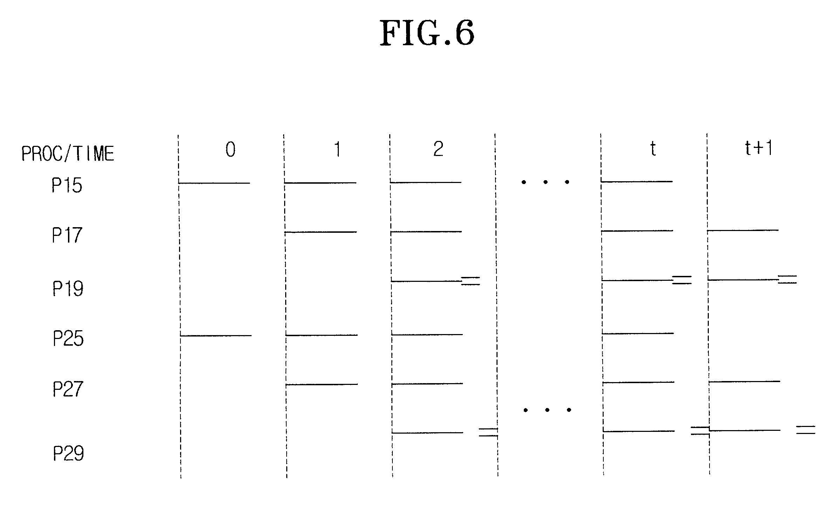

The operation of the (2m) bit input/output decoder for the inner code and the outer code will now be described with reference to Figures 3 through 6. In Figures 5 and 6, a single straight line indicates a predetermined operation in progress, and double straight lines indicate an update operation.

The inner code correction operation will now be explained with reference to Figures 4 and 5. In time period 0, the first RS core 230 receives data in (2m) bit units, and the SYNDCAL1 233 calculates the first syndrome polynomial in (2m) bit units (P11). Thereafter, the second RS core 250 receives data in (2m) bit units, and the SYNDCAL2 253 calculates the second syndrome polynomial in (2m) bit units (P21). Here, the procedures (P11) and (P12) may be carried out in an inverse order. The syndrome calculation is performed in (2m) bit units. Compared with the conventional (m) bit unit syndrome calculation part, the calculation time is reduced into a half. That is, the calculation speed of the syndrome polynomial is increased by two times.

In time period 1, the ERTLCAL1 235 and the ERTLCAL2 255 receive the calculated first and second syndrome polynomials ② and ⑤ and erasure location polynomial ①, and calculate the first and second errata location polynomials ③ and ⑥ (P12, P22). While the errata location polynomial is performed on the first (2m) bit data, the first and second RS cores 230, 250 receive the second (2m) bit data, and calculate the first and second syndrome polynomials ② and ⑤ (P11, P21).

In time period 2, the error value EVAL1 and the error location ELOC1 of the first (2m) bit data is calculated, and the error correction operation is performed. Here, the error correction operation is performed in (m) bit units. Accordingly, the first RS core 230 and the second RS core 250 are alternately enabled under the control of the main control unit 220, to correct the error and update the data (P13, P23). At the same time, the first and second errata location polynomials ③ and ⑥ are calculated on the second (2m) bit data (P12, P22), and the first and second syndrome polynomials ② and ⑤ are calculated on the third (2m) bit data (P11, P21). As described above, the syndrome polynomial calculation ② and ⑤ (P11, P21), the errata location calculation ③ and ⑥ (P12, P22) and the error correction and data updating operations (P13, P23) are simultaneously performed in a predetermined time period after time period 2. When the error correction operation is finished with respect to the inner code, the identical procedure is performed on the two succeeding inner code words. Therefore, the inner code correction operation is performed N1/2 times.

The outer code correction operation will now be described with reference to Figures 4 and 6.

In time period 0, a (2m) bit unit, namely, the two outer codes, is read. The first RS core 230 receives up (m) (UM) bits and the second RS core 250 receives down (m) (DM) bits, thereby calculating the first and second syndrome polynomials ② and ⑤ at the same time. In addition, the ERALCAL 231 receives the erasure flag ERAFLAG, and calculates the erasure location polynomial ① (P15, P25). Accordingly, the syndrome polynomial ② and ⑤ and the erasure location polynomial ① for the two outer codes are obtained during the general (m) bit unit syndrome calculation time.

In time period 1, the ERTLCAL1 235 and the ERTLCAL2 255 receive the calculated first and second syndrome polynomials ② and ⑤ and erasure location polynomial ①, and calculate the first and second errata location polynomials ③ and ⑥ (P17, P27). While the errata location polynomial calculation is performed on the first (2m) bit outer code, the first and second RS cores 230, 250 receive the second (2m) bit outer code, and calculate the first and second syndrome polynomials ② and ⑤ (P15, P25).

In time period 2, the error value EVAL1 and the error location ELOC1 of the first (2m) bit outer code are calculated, and the error correction operation is performed. Here, the error correction operation must be performed in (m) bit units. Accordingly, the first RS core 230 and the second RS core 250 are alternately enabled under the control of the main control unit 220, to correct the error and update the data (P19, P29). At the same time, the first and second errata location polynomials ③ and ⑥ are calculated on the second (2m) bit outer code (P17, P27), and the first and second syndrome polynomials ② and ⑤ are calculated on the third (2m) bit outer codes (P15, P25). As described above, the syndrome polynomial calculation ② and ⑤ (P15, P25), the errata location calculation ③ and ⑥ (P17, P27) and the error correction and data updating operations (P19, P29) are simultaneously performed in a predetermined time period after time period 2. When the error correction operation is finished, the identical procedure is performed on the two succeeding outer code words. Therefore, the outer code correction operation is performed N2/2 times.

The operation of the (2m) bit unit RS decoder was explained above. In order to operate the (m) bit unit RS decoder, an (m) bit correction mode is set. In the (m) bit correction mode, the (m) bit data is stored in an up (m) (UM) bit memory of the storing unit 210, and the second RS core 250 is disabled so that the second RS core 250 cannot access the storing unit 210. Accordingly, the (m) bit unit RS decoder operates in the same way as the conventional (m) bit decoder does.

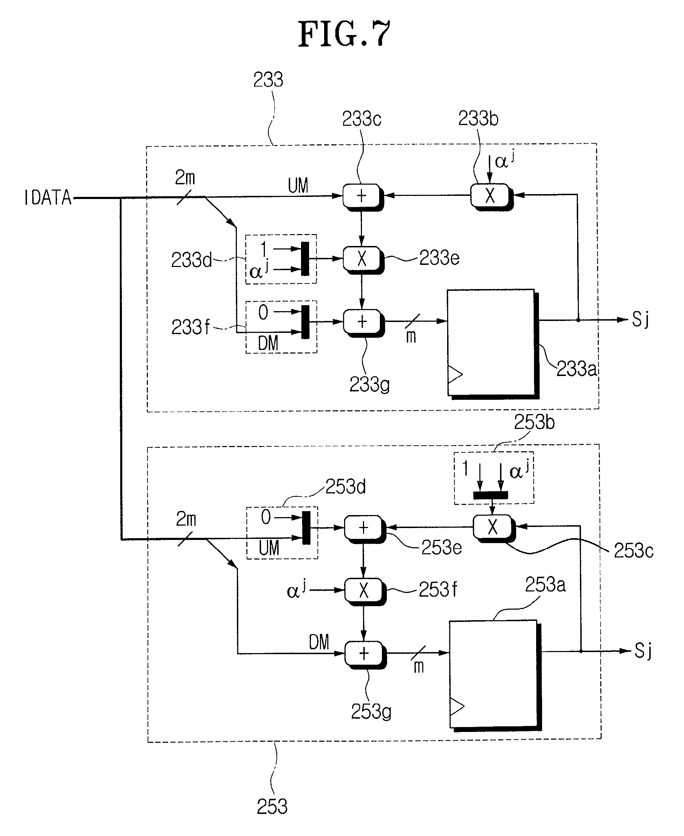

As illustrated in Figure 7, the SYNDCAL1 233 includes a first syndrome storing part 233a, a first multiplier 233b, a first adder 233c, a first (m) bit multiplexer 233d, a second multiplier 233e, a second (m) bit multiplexer 233f and a second adder 233g.

The first syndrome storing part 233a temporarily stores a calculation result of the first syndrome polynomial.

The first multiplier 233b multiplies the syndrome polynomial from the first syndrome storing part 233a by a root α^{j} (j=0, 1, ..., N-K-1) of the generated polynomial.

The first adder 233c adds the output from the first multiplier 233b to up (m) (UM) bits of the input data. The first (m) bit multiplexer 233d respectively outputs 1 or α^{j} according to the (m) or (2m) bit mode.

The second multiplier 233e multiplies the output from the first adder 233c by the output from the first (m) bit multiplexer 233d.

The second (m) bit multiplexer 233f respectively outputs 0 or down (m) (DM) bits of the input data according to (m) or (2m) bit mode.

The second adder 233g adds the output from the second multiplier 233e to the output from the second (m) bit multiplexer 233f. The first syndrome storing part 233a temporarily stores and outputs the output from the second adder 233g.

The SYNDCAL2 253 includes a second syndrome storing part 253a, a third (m) bit multiplexer 253b, a third multiplier 253c, a fourth (m) bit multiplexer 253d, a third adder 253e, a fourth multiplier 253f and a fourth adder 253g.

The second syndrome storing part 253a temporarily stores a calculation result of the second syndrome polynomial.

The third (m) bit multiplexer 253b respectively outputs 1 or α^{j} according to the (m) or (2m) bit mode.

The third multiplier 253c multiplies the output from the second syndrome storing part 253a by the output from the third (m) bit multiplexer 253b.

The fourth (m) bit multiplexer 253d respectively outputs 0 or up (m) (UM) bits of the input data according to (m) or (2m) bit mode.

The third adder 253e adds the output from the third multiplier 253c to the output from the fourth (m) bit multiplexer 253d.

The fourth multiplier 253f multiplies the output from the third adder 253e by a root α^{j} (j=0, 1, ..., N-K-1) of the generated polynomial.

The fourth adder 253g adds the output from the fourth multiplier 253f to the down (m) (DM) bits of the input data. The second syndrome storing part 253a stores and outputs the output from the fourth adder 253g.

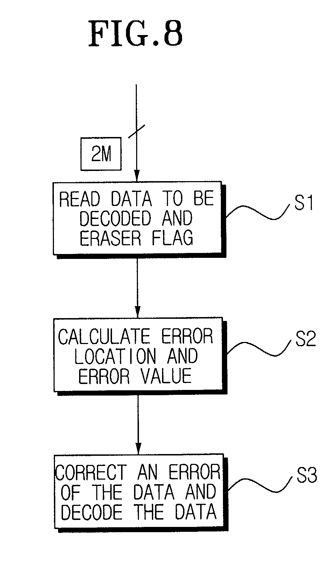

As illustrated in Figure 8, the high speed RS decoding method in accordance with the present invention includes the steps of reading the data to be decoded and an erasure flag (step S1); calculating an error location and an error value from the read data (step S2) ; and correcting an error of the data according to the calculated error location and error value, and decoding the data (step S3).

Preferably, the data is read in (2m) bit units in the data reading step (S1).

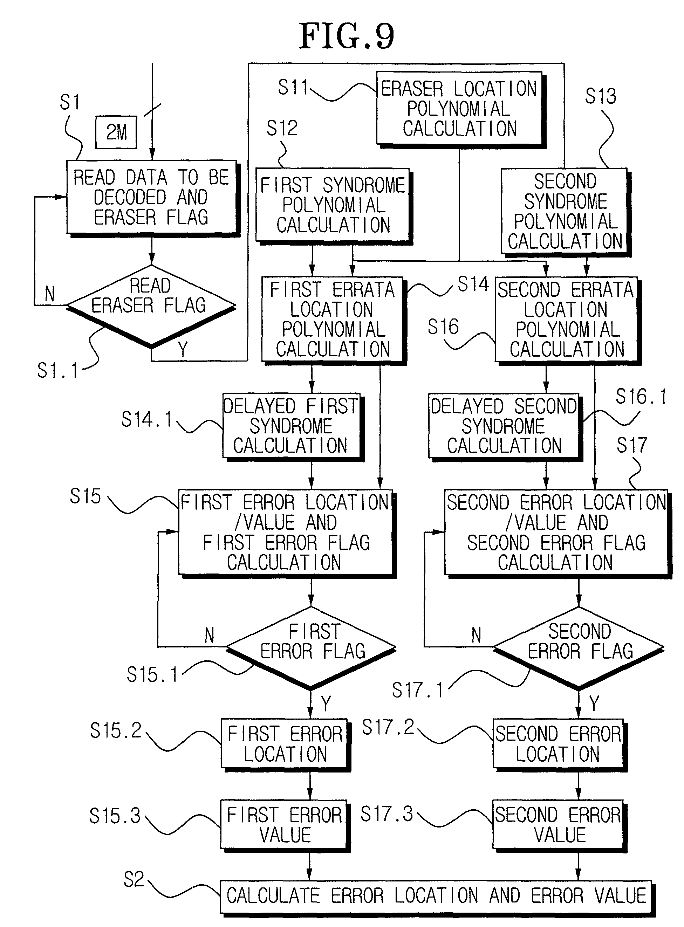

As illustrated in Figure 9, The data reading step (S1) includes a read erasure flag step (S1.1), an erasure location polynomial calculation step (step S11), a first syndrome polynomial calculation step (step S12), a second syndrome polynomial calculation step (step S13), a first errata location polynomial calculation step (step S14), a delayed first syndrome polynomial output step (S14.1), a first error location/value calculation step (step S15), a first error flag calculation output step (S15.1), a first error location calculation output step (S15.2), a first error value calculation output step (S15.3), a second errata location polynomial calculation step (step S16), a delayed second syndrome polynomial output step (S16.1), a second error location/value calculation step (step S17), a second error flag calculation output step (S17.1), a second error location calculation output step (S17.2), and a second error value calculation output step (S17.3).

In the erasure location polynomial calculation step (S11), an erasure location polynomial is calculated by using the read erasure flag (S1.1).

In the first syndrome polynomial calculation step (S12), a first syndrome polynomial is calculated from the read data.

In the second syndrome polynomial calculation step (S13), a second syndrome polynomial is calculated from the read data.

In the first errata location polynomial calculation step (S14), a first errata location polynomial is calculated from the calculated erasure location polynomial and first syndrome polynomial, and the delayed first syndrome polynomial is outputted (S14.1).

In the first error location/value calculation step (S15), a first error flag, a first error location and a first error value are calculated from the first errata location polynomial and the delayed first syndrome polynomial (S14.1). Then, the first error flag is output (S15.1), the first error location is output (S15.2), and the first error value is output (S15.3).

In the second errata location polynomial calculation step (S16), a second errata location polynomial is calculated from the calculated erasure location polynomial and second syndrome polynomial, and the delayed second syndrome polynomial is outputted (S16.1).

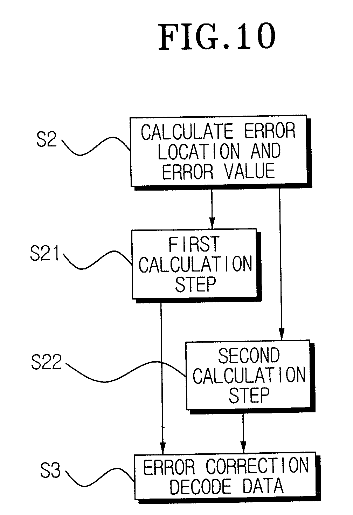

In the second error location/value calculation step (S17), a second error flag, a second error location and a second error value are calculated from the second errata location polynomial and the delayed second syndrome polynomial (S16.1). Then, the second error flag is output (S17.1), the second error location is output (S17.2), and the second error value is output (S17.3). The calculation step (S2) is illustrated in Figure 10. It includes a first calculation step (step S21) and a second calculation step (step S22).

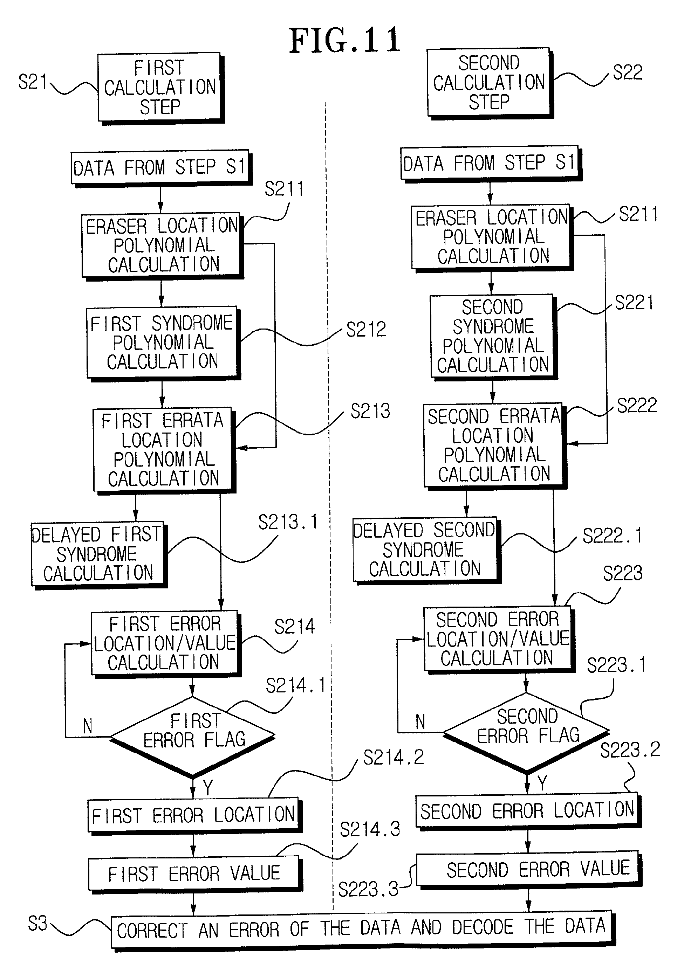

As illustrated in Figure 11, the first calculation step (S21) includes a first error location and a first error value calculated from the read data.

In the second calculation step (S22), a second error location and a second error value are calculated from the read data.

The first calculation step (S21) includes an erasure location polynomial calculation step (step S211), a first syndrome polynomial calculation step (step S212), a first errata location polynomial calculation step (step S213), a delayed first syndrome polynomial output step (S213.1), a first error location/value calculation step (step S214), a first error flag calculation output step (S214.1), a first error location calculation output step (S214.2), and a first error value calculation output step (S214.3).

In the erasure location polynomial calculation step (S211), an erasure location polynomial is calculated from the read erasure flag.

In the first syndrome polynomial calculation step (S212), a first syndrome polynomial is calculated from the read data. The first syndrome polynomial calculation step (S212) satisfies Sⱼ = α^{j}(Sⱼ₋₁α^{j}+UM)+DM when (2m) bit data is inputted, and satisfies Sⱼ = Sⱼ₋₁α^{j}+UM when (m) bit data is inputted. Here, Sⱼ indicates a current state syndrome polynomial, Sⱼ₋₁ is a preceding state syndrome polynomial, α^{j} is a root of the generated polynomial, UM is up (m) bits of the (2m) bit data, and DM is down (m) bits of the (2m) bit data.

In the first errata location polynomial calculation step (S213), a first errata location polynomial is calculated from the calculated erasure location polynomial and first syndrome polynomial, and the delayed first syndrome polynomial is outputted (213.1).

In the first error location/value calculation step (S214), a first error flag, a first error location and a first error value are calculated from the first errata location polynomial and the delayed first syndrome polynomial (213.1). Then, the first error flag is output (S214.1), the first error location is output (S214.2), and the first error value is output (S214.3).

The second calculation step (S22) includes a second syndrome polynomial calculation step (step S221), a second errata location polynomial calculation step (step S222), a delayed second syndrome polynomial output step (S222.1), a second error location/value calculation step (step S223), a second error flag calculation output step (S223.1), a second error location calculation output step (S223.2), and a second error value calculation output step (S223.3).

In the second syndrome polynomial calculation step (S221), a second syndrome polynomial is calculated from the read data. Preferably, the second syndrome polynomial calculation step (S221) satisfies Sⱼ = α^{j}(Sⱼ₋₁α^{j}+UM)+DM when (2m) bit data is inputted, and satisfies Sⱼ = Sⱼ₋₁α^{j}+DM when (m) bit data is inputted.

In the second errata location polynomial calculation step (S222), a second errata location polynomial is calculated from the calculated erasure location polynomial and second syndrome polynomial, and the delayed second syndrome polynomial is outputted (222.1).

In the second error location/value calculation step (S223), a second error flag, a second error location and a second error value are calculated from the second errata location polynomial and the delayed second syndrome polynomial (222.1). Then, the second error flag is output (S223.1), the second error location is output (S223.2), and the second error value is output (S223.3).

According to the present invention, the RS decoder for processing (m) or (2m) bit data and the decoding method therefor can process the data at a high speed, by using the RS cores in parallel. Therefore, it is unnecessary to increase the speed of the operation clocks, thus stabilizing an interface between the storing part and the RS core, and increasing the reliability of the system.

Moreover, the syndrome polynomial calculation part of the RS core selectively processes (m) or (2m) bit data. As a result, the present invention can be employed for CD/DVD data processing of a complicated error correction system. For example, the present invention can be employed for a CD error correction system, which is a Cross Interleaved Reed-Solomon Code (CIRC) that needs to decode data in (m) bit units in order to perform a complicated interleave operation.

While the present invention has been particularly shown and described with reference to the preferred embodiments thereof, it will be understood by those skilled in the art that various changes in form and details may be effected therein without departing from the spirit and scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A Reed-Solomon decoder comprising:
a storing part (210);
a calculation part (230,250) for calculating an error location and an error value from 2m bit data from the storing part; and
a control part (240,260) for correcting an error of the data according to the error location and the error value, and controlling the calculation part to output a decoded signal.

2. The decoder according to claim 1, wherein the calculation part comprises:
an erasure location polynomial calculation part (231) for calculating an erasure location polynomial from an erasure flag from the storing part;
a first syndrome polynomial calculation part (233) for calculating a first syndrome polynomial from the data read from the storing part;
a second syndrome polynomial calculation part (253) for calculating a second syndrome polynomial from the data read from the storing part;
a first errata location polynomial calculation part (235) for calculating a first errata location polynomial from the calculated erasure location polynomial and first syndrome polynomial, and outputting the first errata location polynomial and the delayed first syndrome polynomial;
a first error location/value calculation part (237) for calculating a first error flag, a first error location and a first error value from the first errata location polynomial and the delayed first syndrome polynomial;
a second errata location polynomial calculation part (255) for calculating a second errata location polynomial from the calculated erasure location polynomial and second syndrome polynomial, and outputting the second errata location polynomial and the delayed second syndrome polynomial; and
a second error location/value calculation part (257) for calculating a second error flag, a second error location and a second error value from the second errata location polynomial and the delayed second syndrome polynomial.

3. The decoder according to claim 1, wherein the calculation part (230,250) comprises:
a first RS core (230) for calculating a first error location and a first error value from the data read from the storing part; and
a second RS core (250) for calculating a second error location and a second error value from the data read from the storing part.

4. The decoder according to claim 3, wherein the first RS core (230) comprises:
an erasure location polynomial calculation part (231) for calculating an erasure location polynomial from an erasure flag read from the storing part;
a first syndrome polynomial calculation part (233) for calculating a first syndrome polynomial from the data read from the storing part;
a first errata location polynomial calculation part (235) for calculating a first errata location polynomial from the calculated erasure location polynomial and first syndrome polynomial, and outputting the first errata location polynomial and the delayed first syndrome polynomial; and
a first error location/value calculation part (237) for calculating a first error flag, a first error location and a first error value from the first errata location polynomial and the delayed first syndrome polynomial.

5. The decoder according to claim 4, wherein the first syndrome polynomial calculation part (233) satisfies Sⱼ = α^{j}(Sⱼ₋₁α^{j}+UM)+DM when 2m bit data is inputted; and satisfies Sⱼ = Sⱼ₋₁α^{j}+UM when m bit data is inputted, wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

6. The decoder according to claim 4 or 5, wherein the first syndrome polynomial calculation part (233) comprises:
a first syndrome storing part (233a) for temporarily storing a calculation result of the first syndrome polynomial;
a first multiplier (233b) for multiplying the syndrome polynomial from the first syndrome storing part by a root α^{j}(j=0, 1, ..., N-K-1) of the generated polynomial;
a first adder (233c) for adding the output from the first multiplier to up m (UM) bits of the input data;
a first m bit multiplexer (233d) for outputting 1 or α^{j} according to the m or 2m bit mode;
a second multiplier (233e) for multiplying the output from the first adder by the output from the first m bit multiplexer;
a second m bit multiplexer (233f) for outputting 0 or down m (DM) bits of the input data according to the m or 2m bit mode; and
a second adder (233g) for adding the output from the second multiplier to the output from the second m bit multiplexer, the first syndrome storing part temporarily storing and outputting the output from the second adder;
wherein UM is up m bits of the 2m bit data, and DM is down m bits of the 2m bit data.

7. The decoder according to claim 4, 5 or 6, wherein the second RS core (250) comprises:
a second syndrome polynomial calculation part (253) for calculating a second syndrome polynomial from the data read from the storing part;
a second errata location polynomial calculation part (255) for calculating a second errata location polynomial from the calculated erasure location polynomial and second syndrome polynomial, and outputting the second errata location polynomial and the delayed second syndrome polynomial; and
a second error location/value calculation part (257) for calculating a second error flag, a second error location and a second error value from the second errata location polynomial and the delayed second syndrome polynomial.

8. The decoder according to claim 7, wherein the second syndrome polynomial calculation part (253) satisfies Sⱼ = α^{j}(Sⱼ₋₁α^{j}+UM)+DM when 2m bit data is inputted; and satisfies Sⱼ = Sⱼ₋₁α^{j}+DM when m bit data is inputted, wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

9. The decoder according to claim 7 or 8, wherein the second syndrome polynomial calculation part comprises:
a second syndrome storing part (253a) for temporarily storing a calculation result of the second syndrome polynomial;
a third m bit multiplexer (253b) for outputting 1 or α^{j} according to the m or 2m bit mode;
a third multiplier (253c) for multiplying the output from the second syndrome storing part by the output from the third m bit multiplexer;
a fourth m bit multiplexer (253d) for outputting 0 or up m (UM) bits of the input data according to the m or 2m bit mode;
a third adder (253e) for adding the output from the third multiplier to the output from the fourth m bit multiplexer; and
a fourth multiplier (253f) for multiplying the output from the third adder by a root α^{j}(j=0, 1, ..., N-K-1) of the generated polynomial; and
a fourth adder (253g) for adding the output from the fourth multiplier to down m (DM) bits of the input data, the second syndrome storing part storing and outputting the output from the fourth adder;
wherein UM is up m bits of the 2m bit data, and DM is down m bits of the 2m bit data.

10. A Reed-Solomon decoder for processing m or 2m bit data, comprising:
a storing part (210) for storing 2m bit data;
a main control part (220) for controlling the storing part;
a first RS core (230) for calculating a first error location and a first error value from the data read from the storing part;
a first RS core control part (240) for controlling the first RS core under the control of the main control part;
a second RS core (250) for calculating a second error location and a second error value from the data read from the storing part; and
a second RS core control part (260) for controlling the second RS core under the control of the main control part.

11. The decoder according to claim 10, wherein the first RS core (230) comprises:
an erasure location polynomial calculation part (231) for calculating an erasure location polynomial from an erasure flag from the storing part;
a first syndrome polynomial calculation part (233) for calculating a first syndrome polynomial from the data read from the storing part;
a first errata location polynomial calculation part (235) for calculating a first errata location polynomial from the calculated erasure location polynomial and first syndrome polynomial, and outputting the first errata location polynomial and the delayed first syndrome polynomial; and
a first error location/value calculation part (237) for calculating a first error flag, a first error location and a first error value from the first errata location polynomial and the delayed first syndrome polynomial.

12. The decoder according to claim 11, wherein the first syndrome polynomial calculation part comprises:
a first syndrome storing part (233a) for temporarily storing a calculation result of the first syndrome polynomial;
a first multiplier (233b) for multiplying the syndrome polynomial from the first syndrome storing part by a root α^{j}(j=0, 1, ..., N-K-1) of the generated polynomial;
a first adder (233c) for adding the output from the first multiplier to up m (UM) bits of the input data;
a first m bit multiplexer (233d) for outputting 1 or α^{j} according to the m or 2m bit mode;
a second multiplier (233e) for multiplying the output from the first adder by the output from the first m bit multiplexer;
a second m bit multiplexer (233f) for outputting 0 or down m (DM) bits of the input data according to the m or 2m bit mode; and
a second adder (233g) for adding the output from the second multiplier to the output from the second m bit multiplexer, the first syndrome storing part temporarily storing and outputting the output from the second adder;
wherein UM is up m bits of the 2m bit data, and DM is down m bits of the 2m bit data.

13. The decoder according to claim 12, wherein the first syndrome polynomial calculation part satisfies Sⱼ = α^{j}(Sⱼ₋₁α^{j}+UM) +DM when 2m bit data is inputted; and satisfies Sⱼ = Sⱼ₋₁α^{j}+UM when m bit data is inputted, wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

14. The decoder according to claim 10, 11, 12 or 13 wherein the second RS core (250) comprises:
a second syndrome polynomial calculation part (253) for calculating a second syndrome polynomial from the data read from the storing part;
a second errata location polynomial calculation part (255) for calculating a second errata location polynomial from the calculated erasure location polynomial and second syndrome polynomial, and outputting the second errata location polynomial and the delayed second syndrome polynomial; and
a second error location/value calculation part (257) for calculating a second error flag, a second error location and a second error value from the second errata location polynomial and the delayed second syndrome polynomial.

15. The decoder according to claim 14, wherein the second syndrome polynomial calculation part (253) comprises:
a second syndrome storing part (253a) for temporarily storing a calculation result of the second syndrome polynomial;
a third m bit multiplexer (253b) for outputting 1 or α^{j} according to the m or 2m bit mode;
a third multiplier (253c) for multiplying the output from the second syndrome storing part by the output from the third m bit multiplexer;
a fourth m bit multiplexer (253d) for outputting 0 or up m bits of the input data according to the m or 2m bit mode;
a third adder (253e) for adding the output from the third multiplier to the output from the fourth m bit multiplexer; and
a fourth multiplier (253f) for multiplying the output from the third adder by a root α^{j}(j=0, 1, ..., N-K-1) of the generated polynomial; and
a fourth adder (253g) for adding the output from the fourth multiplier to down m bits of the input data, the second syndrome storing part storing and outputting the output from the fourth adder.

16. The decoder according to claim 14, wherein the second syndrome polynomial calculation part satisfies Sⱼ = α^{j}(Sⱼ₋₁α^{j}+UM)+DM when 2m bit data is inputted; and satisfies Sⱼ = Sⱼ₋₁α^{j}+DM when m bit data is inputted, wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

17. A Reed-Solomon decoding method comprising the steps of:
reading data to be decoded and an erasure flag;
calculating an error location and an error value from the read data; and
correcting an error of the data according to the calculated error location and error value, and decoding the data.

18. The method according to claim 17, wherein the data is read in 2m bit units in the data reading step.

19. The method according to claim 17 or 18, wherein the data reading step comprises:
an erasure location polynomial calculation step for calculating an erasure location polynomial from the read erasure flag;
a first syndrome polynomial calculation step for calculating a first syndrome polynomial from the read data;
a second syndrome polynomial calculation step for calculating a second syndrome polynomial from the read data;
a first errata location polynomial calculation step for calculating a first errata location polynomial from the calculated erasure location polynomial and first syndrome polynomial, and outputting the first errata location polynomial and the delayed first syndrome polynomial;
a first error location/value calculation step for calculating a first error flag, a first error location and a first error value from the first errata location polynomial and the delayed first syndrome polynomial;
a second errata location polynomial calculation step for calculating a second errata location polynomial from the calculated erasure location polynomial and second syndrome polynomial, and outputting the second errata location polynomial and the delayed second syndrome polynomial; and
a second error location/value calculation step for calculating a second error flag, a second error location and a second error value from the second errata location polynomial and the delayed second syndrome polynomial.

20. The method according to claim 17, 18 or 19, wherein the calculation step comprises:
a first calculation step for calculating a first error location and a first error value from the read data; and
a second calculation step for calculating a second error location and a second error value from the read data.

21. The method according to claim 20, wherein the first calculation step comprises:
an erasure location polynomial calculation step for calculating an erasure location polynomial from the read erasure flag;
a first syndrome polynomial calculation step for calculating a first syndrome polynomial from the read data;
a first errata location polynomial calculation step for calculating a first errata location polynomial from the calculated erasure location polynomial and first syndrome polynomial, and outputting the first errata location polynomial and the delayed first syndrome polynomial; and
a first error location/value calculation step for calculating a first error flag, a first error location and a first error value from the first errata location polynomial and the delayed first syndrome polynomial.

22. The method according to claim 21, wherein the first syndrome polynomial calculation step satisfies Sⱼ = α^{j}(Sⱼ₋₁α^{j}+UM)+DM when 2m bit data is inputted; and
satisfies Sⱼ = Sⱼ₋₁α^{j}+UM when m bit data is inputted, wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

23. The method according to claim 20, 21 or 22, wherein the second calculation step comprises:
a second syndrome polynomial calculation step for calculating a second syndrome polynomial from the read data;
a second errata location polynomial calculation step for calculating a second errata location polynomial from the calculated erasure location polynomial and second syndrome polynomial, and outputting the second errata location polynomial and the delayed second syndrome polynomial; and
a second error location/value calculation step for calculating a second error flag, a second error location and a second error value from the second errata location polynomial and the delayed second syndrome polynomial.

24. The method according to claim 23, wherein the second syndrome polynomial calculation step satisfies Sⱼ = α^{j}(Sⱼ₋₁α^{j}+UM)+DM when 2m bit data is inputted; and satisfies Sⱼ = Sⱼ₋₁α^{j}+DM when m bit data is inputted, wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

25. The method according to any of claims 17 to 24, wherein the correcting an error step comprises:
a first error correction step for correcting the read data from the first error value and the first error location from the read data; and
a second error correction step for correcting the read data from the second error value and the second error location from the read data.

26. An inner code correction method of a Reed-Solomon production code, comprising the steps of:
calculating a first syndrome polynomial from inner code words received in 2m bit units;
calculating a second syndrome polynomial from inner code words received in 2m bit units;
calculating first and second errata location polynomials from the calculated first and second syndrome polynomials and an erasure location polynomial; and
calculating first and second error values and first and second error locations according to the first and second errata location polynomials and the first and second syndrome polynomials, the errors being alternately corrected in m bit units.

27. An outer code correction method of a Reed-Solomon production code, comprising the steps of:
calculating a first syndrome polynomial from up m (UM) bits of read 2m bit outer codes and a second syndrome polynomial from down m (DM) bits of read 2m bit outer codes, and simultaneously calculating an erasure location polynomial by reading an erasure flag;
calculating first and second errata location polynomials from the first and second syndrome polynomials and the erasure location polynomial; and
calculating an error value and an error location from the first and second errata location polynomials and the first and second syndrome polynomials, the errors being alternately corrected in m bit units;
wherein UM is up m bits of the 2m bit data, and DM is down m bits of the 2m bit data.

28. The method according to claim 27, wherein, an m bit correction mode is set for an operation of the Reed-Solomon decoder in m bit units, storing the m bit data in an up m bit memory of a storing part, and disabling a second RS core so that the second RS core cannot access the storing part.

29. The method according to claim 26, wherein calculating a first syndrome polynomial and a second syndrome polynomial satisfies Sⱼ = α^{j}(Sⱼ₋₁α^{j}+UM)+DM when 2m bit data is inputted; wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.

30. The method according to claim 27, wherein calculating a first syndrome polynomial and a second syndrome polynomial satisfies Sⱼ = α^{j}(Sⱼ₋₁α^{j}+UM)+DM when 2m bit data is inputted; wherein Sⱼ indicates a current state syndrome polynomial, Sⱼ₋₁ is a preceding state syndrome polynomial, α^{j} is a root of a generated polynomial, UM is up m bits of the 2m bit data, and DM is down m bits of the 2m bit data.
